# EUROPEAN PATENT APPLICATION

(11) **EP 3 750 657 A1**
(43) Date of publication of application: **16.12.2020**
(21) Application number: 19212148.1
(22) Date of filing: 28.11.2019
(51) Int. Cl.: B23K 1/00, B23K 1/008, B23K 3/04, H05K 3/34, B23K 101/42

(54) **VACUUM REFLOW OVEN**

(30) Priority: 06.08.2019 TW 108210367 U
(71) Applicant: 3S Silicon Tech, Inc., Sinfong Township, Hsinchu County (TW)
(72) Inventor: PENG, Jung-Kuei, HSINCHU COUNTY (TW); YEH, Kuo-Liang, HSINCHU COUNTY (TW); CHEN, Yu-Tao, HSINCHU COUNTY (TW); HUANG, Wen-Ting, HSINCHU COUNTY (TW); HUANG, Cheng-Shang, HSINCHU COUNTY (TW)
(74) Representative: Pallini Gervasi, Diego

(57) **Abstract**

A vacuum reflow oven has a table (10), a top cover (20), multiple heating seats (30), and multiple vacuum enclosures (41). The top cover (20) is openably mounted on the table (10). The heating seats (30) are mounted on the table (10) in a linear arrangement. The vacuum enclosures (41) are mounted on the top cover (20), are each corresponding to a respective one of the heating seats (30) in position, and are moved relative to the top cover (20) to cover and seal the corresponding heating seats (30) to form vacuum chambers (42). The formic acid gas is input into the vacuum chambers (42) to enhance the utilization and reduce consumption of formic acid gas. Because of the multiple vacuum chambers (42), reaction cycle is reduced, production capacity is enhanced, and tin powders can be reduced completely to enhance soldering strength.

## Description

### 1. Field of the Invention

The present invention relates to a reflow oven, especially to a vacuum reflow oven that is able to form vacuum chambers therein.

### 2. Description of Related Art

In conventional surface-mount technology, since solder flux of the solder paste would cause some defects that deteriorate solder quality, a surface-mount technology using formic acid gas instead of the solder flux has been developed.

The main point of the technology is inputting the formic acid gas during the soldering process. The semi-finished soldering component (including metal to be soldered and a mess of solder powders for soldering) is exposed in the formic acid gas throughout the entire gradual heating process. The formic acid gas is applied for reducing the surface oxide formed on the metal surfaces to improve solder quality. However, a specific temperature is required to start the reduction reaction of the metals. Inputting the formic acid gas throughout the entire process causes disadvantages of lower formic acid gas utilization and higher formic acid gas consumption to increase costs. Moreover, the formic acid gas is inputted into an opening space in the technology, and the formic acid gas would leak into the air to affect the environment and human health.

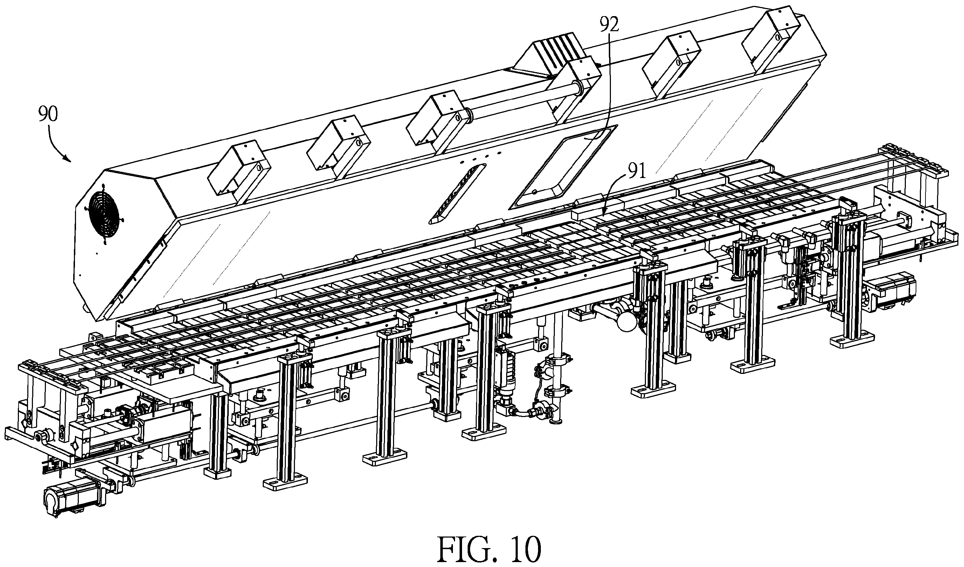

To overcome the shortcomings, a vacuum reflow oven has been developed. With reference to Fig. 10, the conventional vacuum reflow oven 90 has multiple heating seats 91 and a vacuum enclosure 92. The heating seats 91 are arranged sequentially from lowest heating temperature to highest high temperature. The semi-finished soldering component is sequentially moved to each heating heat 91 for being gradually heated. The vacuum enclosure 92 covers one of the heating seats 91 to form a vacuum chamber. Thus, the formic acid gas may be inputted into the vacuum chamber under a specific temperature to reduce tin solders and surface oxide on the metal to be soldered. Therefore, the formic acid utilization can be enhanced to reduce costs, and residual formic disposal is easily prevented from affecting the environment and human health.

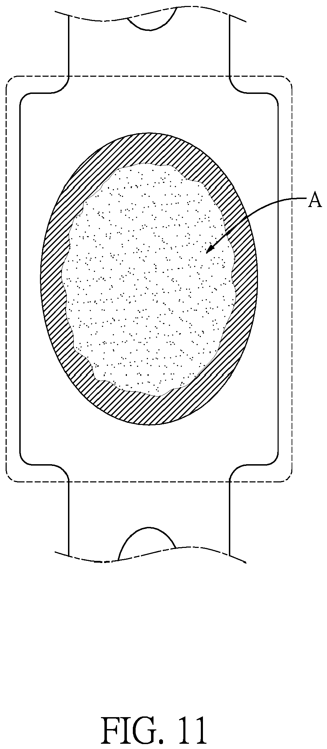

However, the conventional vacuum reflow oven has the following defects:
1. With reference to Fig. 11, to avoid the solder powders being oxidized again after the reducing process, the temperature of the vacuum chamber reaches the melting temperature of tin powders (A). The formic acid gas diffuses into an inner portion of the tin powders (A) from edges thereof. After exposure to the formic acid gas, the tin powders (A) at the edges would start reducing and melting, and would become a liquid enclosure formed around the inner tin powders (A) to isolate the inner tin powders (A) from the exterior environment. The formic acid gas cannot diffuse into the inner portion of the tin powders (A) after the tin powders (A) at the edges completely melt. Thus, the inner tin powders (A) cannot be reduced, and the soldering strength and solder quality are negatively affected.
2. Various metals may be used in the soldering process. For example, copper is soldered to iron via tin. The metals may respectively have a specific reducing temperature. If the formic acid gas is inputted to the vacuum chamber at a particular temperature, some of the metals may not be reduced, or may be reduced after a longer period of time. The soldering strength is reduced because of the metal surface oxides, and the soldering efficiency is reduced.

To overcome the shortcomings, the present invention tends to provide a vacuum reflow oven with multiple vacuum chambers to mitigate or obviate the aforementioned problems.

The main objective of the invention is to provide a vacuum reflow oven, which has multiple vacuum chambers formed therein for inputting the formic acid gas. Thus, the formic acid can completely diffuse into inner portions of tin solder powders, and specific temperatures for the redox reactions of the different metals can be provided.

A vacuum reflow oven applied for soldering a component comprises a table, a top cover, multiple heating seats, multiple vacuum enclosures, multiple driving units, multiple vacuum pipes, and at least one transmitting unit.

The table has two opposite ends respectively defined as an entry end and an export end, and a first side and a second side being opposite each other. The first side and the second side are parallel to a connecting line of the entry end and the export end. The top cover selectively covers the table. The heating seats are mounted on the table and are arranged from the entry end to the export end. The vacuum enclosures are mounted on the top cover. Each of the vacuum enclosures corresponds to a respective one of the heating seats in position when the top cover covers the table. Each vacuum enclosure is movable vertically relative to the top cover and covers and seals the corresponding heating seat to form a vacuum chamber. The driving units are mounted in the top cover, and are respectively connected to and drive the vacuum enclosures to vertically move relative to the top cover. The vacuum pipes respectively communicate with the vacuum chambers formed by the vacuum enclosures for exhausting air from the vacuum chambers. The at least one transmitting unit is connected with the table and transmits the component to each heating seat sequentially from the entry end to the export end.

Other objects, advantages and novel features of the invention will become more apparent from the following detailed description when taken in conjunction with the accompanying drawings.

### IN THE DRAWINGS:

Fig. 1 is a perspective view of an embodiment of a vacuum reflow oven in accordance with the present invention;
Fig. 2 is an enlarged perspective view of the vacuum reflow oven in Fig. 1;
Fig. 3 is an enlarged perspective view in partial section of the vacuum reflow oven in Fig. 1;
Fig. 4 is an exploded perspective view of a vacuum enclosure, a vacuum seat and a heating seat in Fig. 1;
Fig. 5 is top view of the table in Fig.1;
Figs. 6 to 9 are operational side views of the vacuum reflow oven in Fig. 1, showing transmitting motions of the transmitting unit;
Fig. 10 is a perspective view of a conventional vacuum reflow oven; and
Fig.11 is a cross sectional top view of a soldered component by the conventional vacuum reflow oven in Fig. 10.

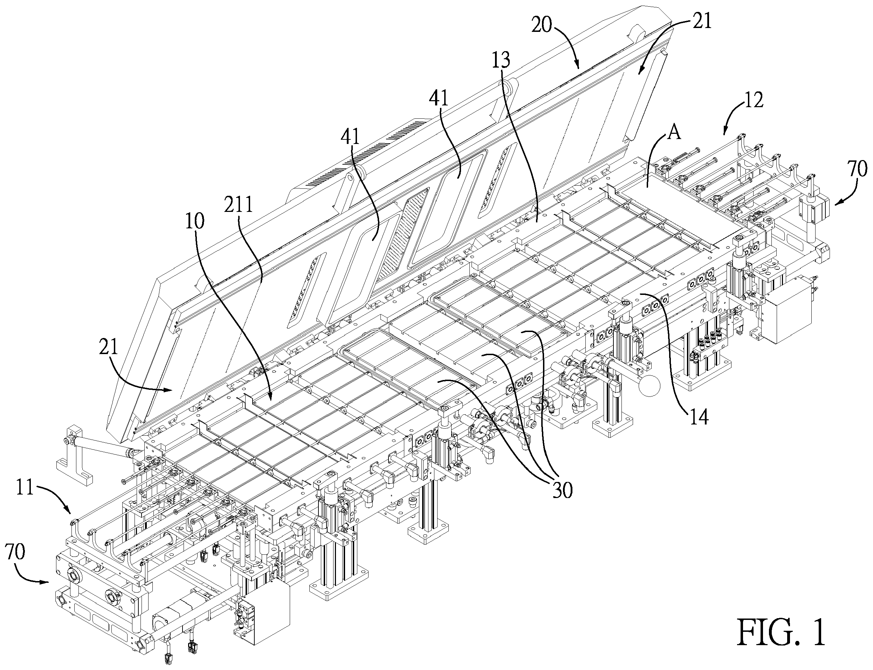

With reference to Figs. 1 to 3, a vacuum reflow oven in accordance with the present invention is applied for soldering a component A. In the embodiment, the vacuum reflow oven has a table 10, a top cover 20, multiple heating seats 30, multiple vacuum enclosures 41, multiple driving units 50, multiple vacuum pipes 60, and at least one transmitting unit 70.

The table 10 has two opposite ends respectively defined as an entry end 11 and an export end 12. The table 10 has a first side 13 and a second side 14 being opposite each other. The first side 13 and the second side 14 are parallel to a connecting line of the entry end 11 and the export end 12; in other words, the first side 13 and the second side 14 are two sides of the table 10 different from the entry end 11 and the export end 12.

The top cover 20 selectively covers the table 10, and is pivotally openable and mounted on the top of the table 10. The top cover 20 is pivotally connected to the first side 13 of the table 10. The vacuum reflow oven of the embodiment further comprises a cover pressing unit 80 mounted on the second side 14 of the table 10. The cover pressing unit 80 is applied for pressing and fixing the top cover 20 when the top cover 20 covers the table 10 to ensure airtightness of the vacuum chamber. In addition, the top cover 20 of the embodiment has two air curtain units 21 respectively being adjacent to the entry end 11 and the export end 12 of the table 10. Each air curtain unit 21 has multiple vents 211 formed through a surface of the top cover 20 facing the table 10, and the vents 211 of each air curtain unit 21 are arranged from the first side 13 to the second side 14 when the top cover 20 covers the table 10. In other words, the arrangement of the vents 211 does not have to be perpendicular to the connecting line of the entry end 11 and the export end 12. The vents 211 may be in an inclined arrangement or a curved arrangement and are arranged from the first side 13 to the second side 14. Thus, a nitrogen supply unit is connected to the vents 211 to form nitrogen gas curtains on the entry end 11 and the export end 12 respectively. The oxygen content between the top cover 20 and the table 10 during the soldering process can be reduced to prevent the component A from contacting the oxygen and being oxidized.

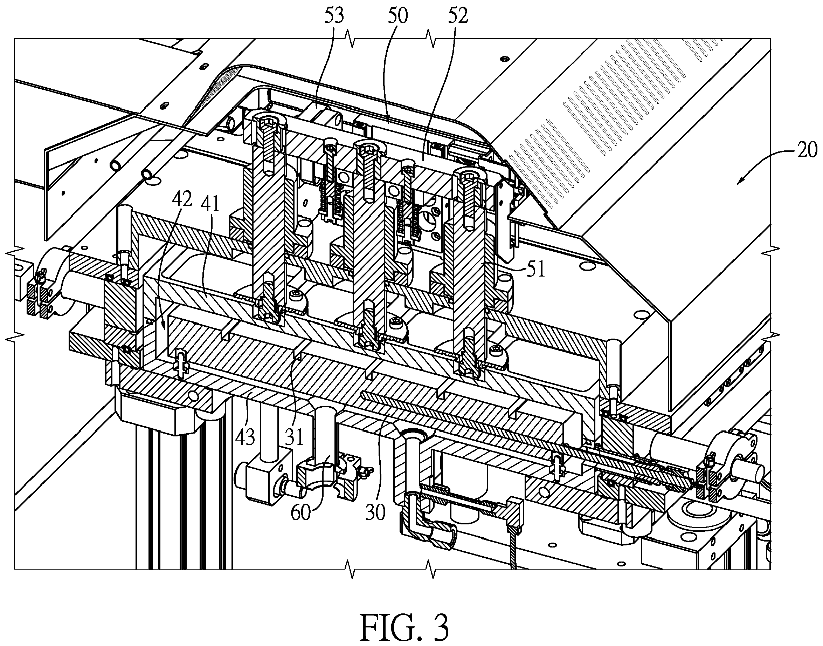

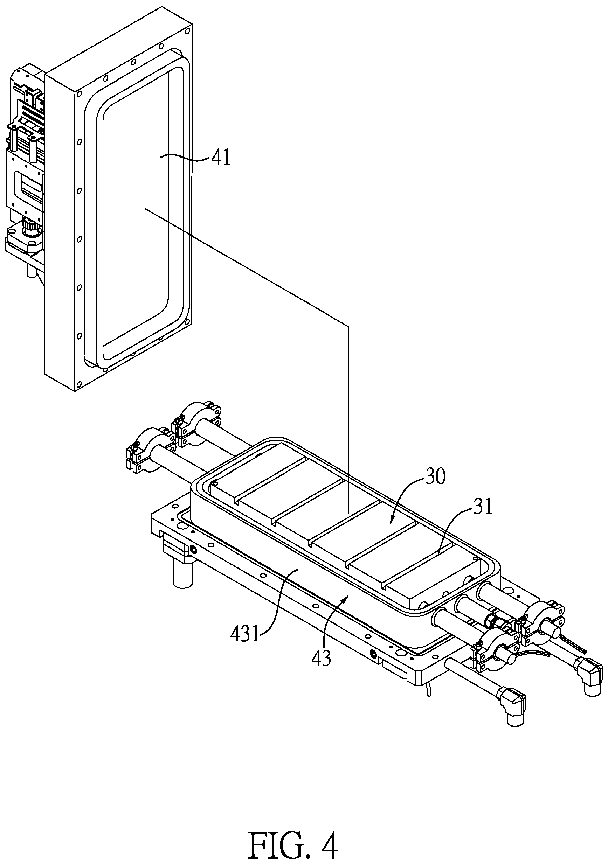

With reference to Figs. 3 to 5, the heating seats 30 are mounted on the table 10 and are arranged from the entry end 11 to the export end 12. In addition, each heating seat 30 has multiple grooves 31 recessed in the top of the heating seat 30. The grooves 31 of each heating seat 30 are arranged in parallel at spaced intervals. Each groove 31 extends parallel to the connecting line of the entry end 11 and the export end 12 of the table 10 and is formed through side surfaces of the heating seat 30. The grooves 31 of each two of the heating seats 30 are arranged in corresponding positions. Thus, the grooves 31 of the heating seats 30 in corresponding positions are aligned along the direction from the entry end 11 to the export end 12 and communicate with each other. In other words, any of the grooves 31 of the heating seat 30 adjacent to the entry end 11 communicates, all the way through a linear line, with the corresponding groove 31 of the heating seat 30 that is closest to the export end 12.

With reference to Figs. 1,3, and 5, the vacuum enclosures 41 are mounted on the top cover 20, and each vacuum enclosure 41 corresponds to a respective one of the heating seats 30 in position when the top cover 20 covers the table 10. Each vacuum enclosure 41 is movable vertically relative to the top cover 20 and covers and seals the corresponding heating seat 30 to form a vacuum chamber 42. The vacuum reflow oven further comprises multiple vacuum seats 43 mounted on the table 10. Each vacuum seat 43 has a peripheral wall 431. The heating seats 30 corresponding to the vacuum enclosures 41 are respectively surrounded by the peripheral walls 431 of the vacuum seats 43. The vacuum enclosures 41 respectively seal the peripheral walls 431 of the vacuum seats 43 to form the vacuum chambers 42. The structure that the vacuum chambers 42 are formed by the vacuum enclosures 41 is not limited to the abovementioned. For example, in another embodiment, the table 10 does not have the vacuum seats 43 mounted thereon. The heating seats 30 are directly mounted on the table 10, and the vacuum enclosures 41 directly seal the table 10 to form airtight vacuum chambers 42. In addition, two vacuum enclosures 41 are disclosed in the embodiment for example, and the vacuum reflow oven in accordance with the present invention may comprise more than two vacuum enclosures 41 for providing appropriate reduction conditions respectively to different metals.

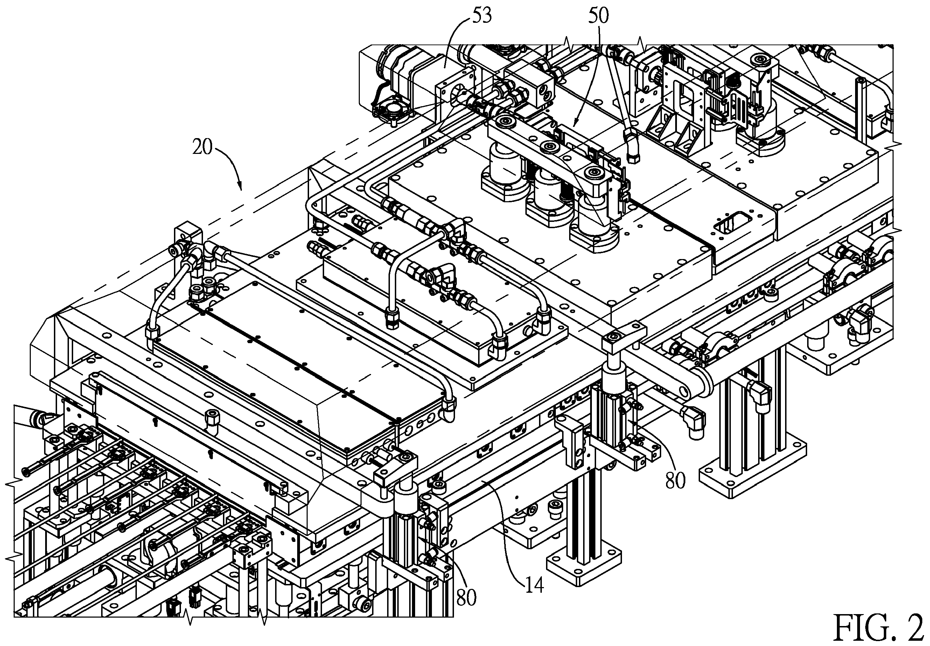

With reference to Figs. 2 and 3, the driving units 50 are mounted in the top cover 20 and are respectively connected to the vacuum enclosures 41. The driving unit 50 drives the vacuum enclosures 41 to move vertically relative to the top cover 20. In the embodiment, each driving unit 50 has multiple moving rods 51, a moving seat 52, and a driving device 53. The moving rods 51 are parallel to each other. An end of each moving rod 51 is fixed in the connected vacuum enclosure 41. Each moving rod 51 is fixed to the moving seat 52 in an axial direction of the moving rod 51. Some of the moving rods 51 are radially movably mounted in the moving seat 52 along radial directions of the moving rods 51. In the embodiment, the moving rod 51 located in the middle is radially fixed to the moving seat 52, and the moving rods 51 located at opposite sides are radially movably mounted in the moving seat 52 in the radial directions of the moving rods 51. When the vacuum enclosure 41 is in thermal expansion, the relative distance of the moving rods 51 would be increased, and positions of the ends of the moving rods 51 connected to the moving seat 52 can move relatively, thus the moving rods 51 can be kept parallel and linearly moved. The driving device 53 is fixed in the top cover 20 and is connected to the moving seat 52. The driving device 53 drives the moving seat 52 and the moving rods 51 to move relative to the top cover 20 along the axial direction of the moving rods 51 to drive the vacuum enclosure 41 to move vertically relative to the top cover 20.

The vacuum pipes 60 communicate with the vacuum chambers 42 formed by the vacuum enclosure 41 respectively, and are connected to a vacuum generating apparatus to exhaust air from the vacuum chambers 42. In the embodiment, the vacuum pipes 60 are mounted through the table 10 and are respectively mounted through bottoms of the vacuum seats 43 to communicate with the vacuum chambers 42, but it is not limited thereto. The vacuum pipes 60 may be mounted through the vacuum enclosures 41 to communicate with the vacuum chambers 42.

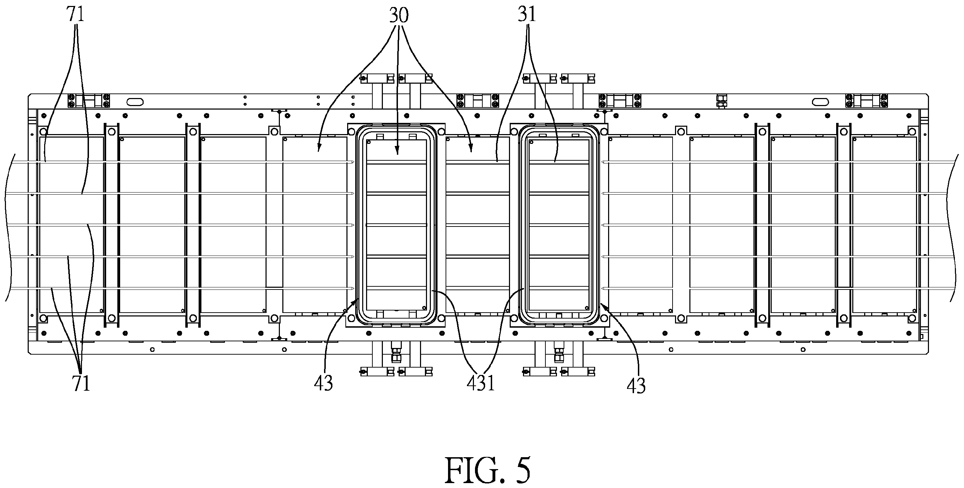

With reference to Figs. 1 and 5, the transmitting unit 70 is connected to the table 10, and transmits the component A to each heating seat 30 sequentially from the entry end 11 to the export end 12.

With reference to Figs. 5 to 9, in the embodiment, the transmitting unit 70 has multiple jacking rods 71, a horizontal driving assembly 72, and a vertical driving assembly 73. The jacking rods 71 extend parallel to the connecting line of the entry end 11 and the export end 12 of the table 10, and is mounted through the grooves 31 of the heating seats 30. The horizontal driving assembly 72 is connected with the jacking rods 71 and drives the jacking rods 71 to move reciprocally along the connecting line of the entry end 11 and the export end 12 of the table 10. The vertical driving assembly 73 is connected with the horizontal driving assembly 72, and drives the horizontal driving assembly 72 to move up and down reciprocally for moving the jacking rods 71 protruding from the grooves 31 or being below the top surfaces of the heating seats 30. Thus, the transmitting unit 70 can transmit the component A to each heating seat 30 sequentially by the cooperative operation of the units of the transmitting unit 70.

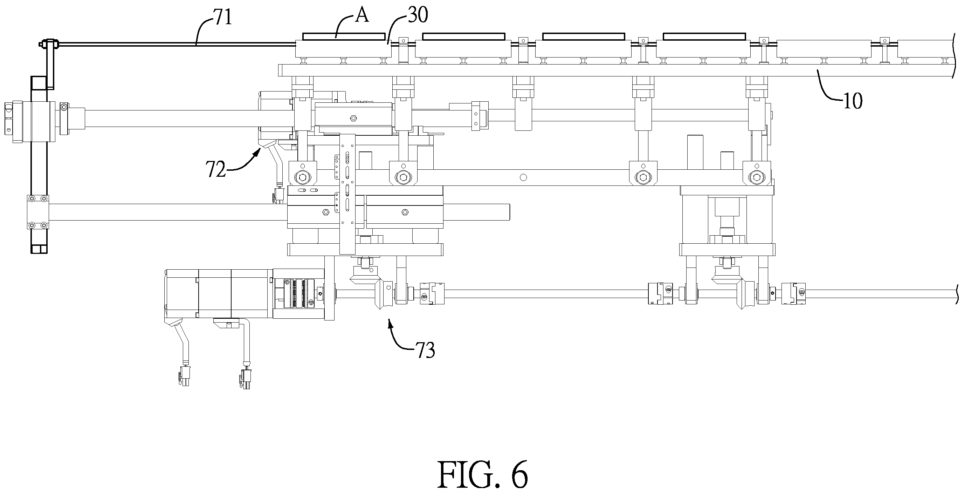

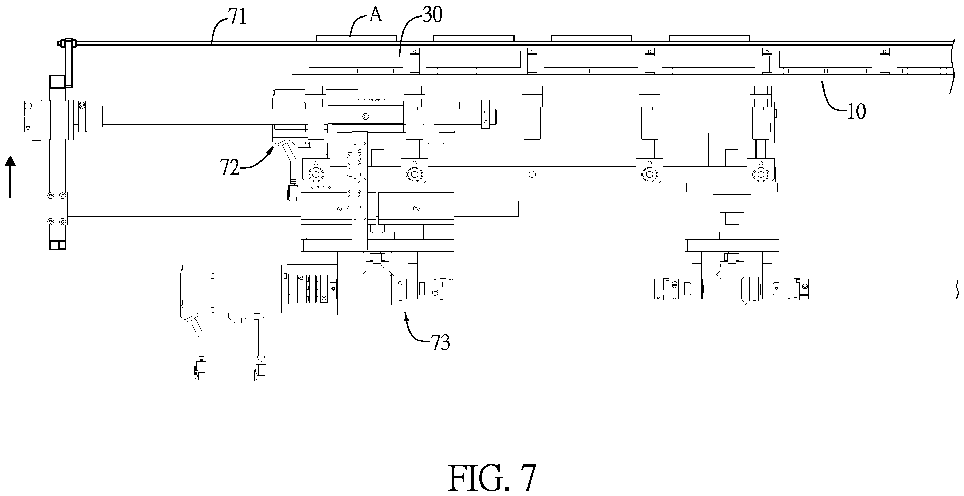

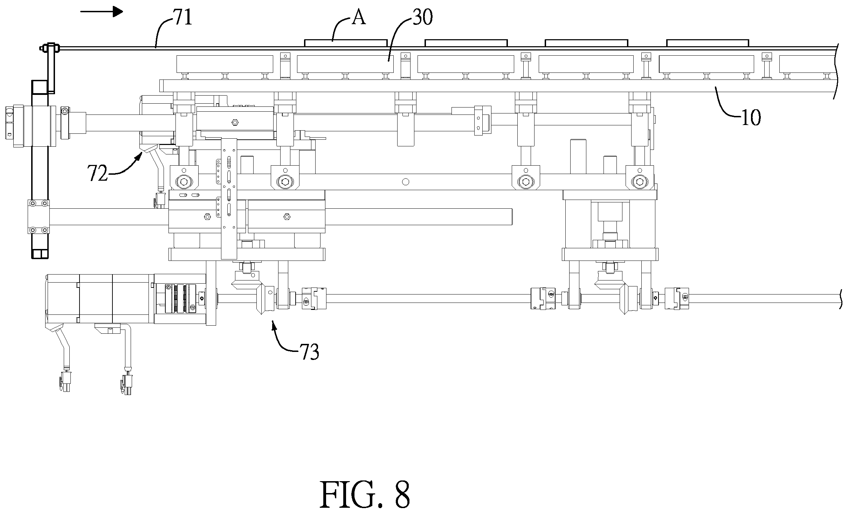

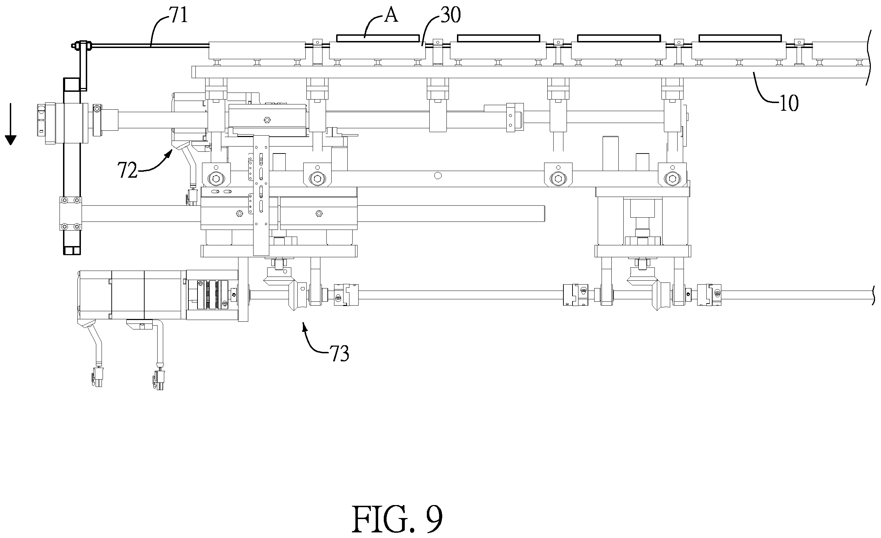

The operating process of the transmitting unit 70 is as follows. With reference to Fig.6, firstly, the component A is put on a heating seat 30 for heating, and the jacking rods 71 are disposed in the grooves 31. To transmit the component A to the next heating seat 30, with reference to Fig. 7, the vertical driving assembly 73 is operated to move the horizontal driving assembly 72 and the jacking rods 71 upwardly, and the jacking rods 71 jack up the component A away from the top surfaces of the heating seats 30. With reference to Fig. 8, the horizontal driving assembly 72 is operated to move the jacking rods 71 from the entry end 11 to the export end 12, and the component A is horizontally moved toward the next heating seat 30 at a position above the heating seats 30. With reference to Fig. 9, the vertical driving assembly 73 is operated to move the horizontal driving assembly 72 down, and the jacking rods 71 are moved with the horizontal driving assembly 72 and are returned to the grooves 31. The component A is placed on the top surface of the heating seat 30 to complete the transmitting process of the component A. After that, the horizontal driving assembly 72 is returned to the preset position from the export end 12 to the entry end 11, and wait till the next transmitting process. The component A will not be shifted, because the jacking rods 71 are moved through the grooves 31 under the top surfaces of the heating seats 30.

In addition, the vacuum reflow oven comprises two transmitting units 70 respectively mounted on the entry end 11 and the export end 12 of the table 10 and cooperating with each other. With reference to Fig. 5, the jacking rods 71 of the transmitting units 70 may respectively be moved away to the opposite sides of the vacuum enclosures 41 while the vacuum enclosures 41 are moving down and sealing the heating seats 30, and may be moved in the heating seats 30 mounted in the vacuum seats 43 while transmitting the component A. Thus, the moving distance of the horizontal driving assembly 72 of each transmitting unit 70 may be reduced, and the total size of the transmitting unit 70 can be reduced. The structures and the operating process of the transmitting units 70 are not limited to the abovementioned. For example, the transmitting unit 70 may be a mechanical manipulator.

In the soldering process, the component A is putted on the heating seat 30 having the lowest heating temperature from the entry end 11, is sequentially transmitted toward the export end 12, and is sequentially moved to the next heating seats 30 having gradually higher heating temperatures by the transmitting unit 70 for gradually heating. When the component A is transmitted to the heating seat 30 mounted in a first vacuum seat 43, the jacking rods 71 of the transmitting units 70 are respectively moved to the opposite sides of the vacuum seat 43, and the vacuum enclosure 41 is moved down and seals the vacuum seat 43 to form the vacuum chamber 42. After that, the air inside the vacuum chamber 42 is exhausted through the vacuum pipes 60. After the vacuum chamber 42 is under vacuum, the formic acid gas is inputted into the vacuum chamber 42 through formic acid pipes. Because the temperature of the vacuum chamber 42 is lower than the melting temperature of the tin, the formic acid gas can completely diffuse into an inner portion of tin powders and start the reducing process. At this time, the formic acid gas can reduce metal oxides on metal surfaces having lower reduction temperature, such as copper. After that, the vacuum enclosure 41 is moved up to the preset position, and the component A is transmitted to the next heating seat 30. When the component A is transmitted to the heating seat 30 having a temperature reaching the melting temperature of tin, the vacuum enclosure 41, the vacuum seat 43, the vacuum pipes 60, and the formic acid pipes are operated to form a vacuum and the formic acid gas is inputted. The tin powders are melting and reducing at the same time. At last, the component A is moved out from the heating seat 30 having the highest heating temperature and cools down, and the molten tin is cooling and solidified to complete the soldering process.

The vacuum reflow oven in accordance with the present invention can respectively input formic acid gas into the vacuum chambers 42 to provide the appropriate reduction conditions for various metals. The metals may respectively be reduced under different temperatures, so a reaction cycle can be reduced, and production capacity can be enhanced. In addition, the metal surface oxides can be reduced to enhance soldering strength. The vacuum reflow oven has multiple vacuum chambers 42, the formic acid gas can be input into a vacuum chamber 42 with temperature lower than the melting temperature of tin, and the formic acid gas can completely diffuse into the inner portion of the tin powders to reduce the inner tin powders without blocking by melting tin powders at outer edges of the tin powders to enhance the soldering strength.

## Claims

1. A vacuum reflow oven applied for soldering a component (A), **characterized in that** the vacuum reflow oven comprises:
a table (10) having
two opposite ends respectively defined as an entry end (11) and an export end (12);
a first side (13) and a second side (14) being opposite each other, and the first side (13) and the second side (14) being parallel to a connecting line of the entry end (11) and the export end (12);
a top cover (20) selectively covering the table (10);
multiple heating seats (30) mounted on the table (10) and arranged from the entry end (11) to the export end (12);
multiple vacuum enclosures (41) mounted on the top cover (20), each of the vacuum enclosures (41) corresponding to a respective one of the heating seats (30) in position when the top cover (20) covers the table (10), each of the vacuum enclosures (41) being movable vertically relative to the top cover (20) and covering and sealing the corresponding heating seat (30) to form a vacuum chamber (42);
multiple driving units (50) mounted in the top cover (20), respectively connected to and driving the vacuum enclosures (41) to vertically move relative to the top cover (20);
multiple vacuum pipes (60) respectively communicating with the vacuum chambers (42) formed by the vacuum enclosures (41) for exhausting air from the vacuum chambers (42); and
at least one transmitting unit (70) connected with the table (10) and transmitting the component (A) to each heating seat (30) sequentially from the entry end (11) to the export end (12).

2. The vacuum reflow oven as claimed in claim 1, wherein each of the driving units (50) has
multiple moving rods (51) being parallel with each other, an end of each of the moving rods (51) fixed in the connected vacuum enclosure (41);
a moving seat (52) connected with ends of the moving rods (51) away from the vacuum enclosure (41), each of the moving rods (51) axially fixed in the moving seat (52) in an axial direction of the moving rod (51), and some of the moving rods (51) radially movably mounted in the moving seat (52) along radial directions of the moving rods (51); and
a driving device (53) fixed in the top cover (20) and connected to the moving seat (52), the driving device (53) driving the moving seat (52) and the moving rods (51) to move relative to the top cover (20) along the axial direction of the moving rods (51) to drive the vacuum enclosure (41) to move relative to the top cover (20).

3. The vacuum reflow oven as claimed in claim 1 or 2, wherein the top cover (20) has
two air curtain units (21) respectively being adjacent to the entry end (11) and the export end (12) of the table (10), and each of the air curtain units (21) has
multiple vents (211) formed through a surface of the top cover (20) facing the table (10), the vents (211) of each of the air curtain units (21) arranged from the first side (13) to the second side (14) of the table (10) when the top cover (20) covers the table (10).

4. The vacuum reflow oven as claimed in claim 1 or 2, wherein
each of the heating seats (30) has multiple grooves (31) recessed in a top of the heating seat (30), the grooves (31) of each of the heating seats (30) are arranged in parallel at spaced intervals, extend along the connecting line of the entry end (11) and the export end (12) of the table (10), and are formed through side surfaces of the heating seat (30), the grooves (31) of each two of the heating seats (30) are arranged in corresponding positions;
the at least one transmitting unit (70) has
multiple jacking rods (71) extending along the connecting line of the entry end (11) and the export end (12) of the table (10) and mounted through the grooves (31) of the heating seats (30);
a horizontal driving assembly (72) connected with the jacking rods (71) and driving the jacking rods (71) to move reciprocally along the connecting line of the entry end (11) and the export end (12); and
a vertical driving assembly (73) connected with the horizontal driving assembly (72) and driving the horizontal driving assembly (72) to move up and down reciprocally for moving the jacking rods (71) selectively protruding from the grooves (31) or being below top surfaces of the heating seats (30).

5. The vacuum reflow oven as claimed in claim 1 or 2, wherein
the top cover (20) is pivotally connected to the first side (13) of the table (10);
the vacuum reflow oven further comprises a cover pressing unit (80) mounted on the second side (14) of the table (10), the cover pressing unit (80) presses and fixes the top cover (20) when the top cover (20) covers the table (10).

6. The vacuum reflow oven as claimed in claim 1 or 2, wherein
the vacuum reflow oven further comprises multiple vacuum seats (43) mounted on the table (10), and each of the vacuum seats (43) has a peripheral wall (431);
the heating seats (30) corresponding to the vacuum enclosures (41) are respectively surrounded by the peripheral walls (431) of the vacuum seats (43);
the vacuum enclosures (41) respectively seal the peripheral walls (431) of the vacuum seats (43) to form the vacuum chambers (42); and
the vacuum pipes (60) are mounted through the table (10) and respectively mounted through bottom surfaces of the vacuum seats (43).

## Amended claims

### Amended claims in accordance with Rule 137(2) EPC.

1. A vacuum reflow oven applied for soldering a component (A), the vacuum reflow oven comprising:
a table (10) having
two opposite ends respectively defined as an entry end (11) and an export end (12);
a first side (13) and a second side (14) being opposite each other, and the first side (13) and the second side (14) being parallel to a connecting line of the entry end (11) and the export end (12);
a top cover (20) pivotally connected to the first side (13) of the table (10) and selectively covering the table (10);
multiple heating seats (30) mounted on the table (10) and arranged from the entry end (11) to the export end (12), each of the heating seats (30) having multiple grooves (31) recessed in a top of the heating seat (30), the grooves (31) of each of the heating seats (30) arranged in parallel at spaced intervals, extending along the connecting line of the entry end (11) and the export end (12) of the table (10), and formed through side surfaces of the heating seat (30), and the grooves (31) of each two of the heating seats (30) arranged in corresponding positions;
at least one transmitting unit (70) connected with the table (10) and transmitting the component (A) to each heating seat (30) sequentially from the entry end (11) to the export end (12), the at least one transmitting unit (70) having
multiple jacking rods (71) extending along the connecting line of the entry end (11) and the export end (12) of the table (10) and mounted through the grooves (31) of the heating seats (30);
a horizontal driving assembly (72) connected with the jacking rods (71) and driving the jacking rods (71) to move reciprocally along the connecting line of the entry end (11) and the export end (12); and
a vertical driving assembly (73) connected with the horizontal driving assembly (72) and driving the horizontal driving assembly (72) to move up and down reciprocally for moving the jacking rods (71) selectively protruding from the grooves (31) or being below top surfaces of the heating seats (30);
a cover pressing unit (80) mounted on the second side (14) of the table (10), the cover pressing unit (82) pressing and fixing the top cover (20) when the top cover (20) covers the table (10), **characterized in that** the vacuum reflow oven comprises:
multiple vacuum enclosures (41) mounted on the top cover (20), each of the vacuum enclosures (41) corresponding to a respective one of the heating seats (30) in position when the top cover (20) covers the table (10), each of the vacuum enclosures (41) being movable vertically relative to the top cover (20) and covering and sealing the corresponding heating seat (30) to form a vacuum chamber (42);
multiple vacuum seats (43) mounted on the table (10), and each of the vacuum seats (43) having a peripheral wall (431), wherein the heating seats (30) corresponding to the vacuum enclosures (41) are respectively surrounded by the peripheral walls (431) of the vacuum seats (43), and the vacuum enclosures (41) respectively seal the peripheral walls (431) of the vacuum seats (43) to form the vacuum chambers (42);
multiple driving units (50) mounted in the top cover (20), respectively connected to and driving the vacuum enclosures (41) to vertically move relative to the top cover (20), and each of the driving units (50) having
multiple moving rods (51) being parallel with each other, an end of each of the moving rods (51) fixed in the connected vacuum enclosure (41);
a moving seat (52) connected with ends of the moving rods (51) away from the vacuum enclosure (41), each of the moving rods (51) axially fixed in the moving seat (52) in an axial direction of the moving rod (51), and some of the moving rods (51) radially movably mounted in the moving seat (52) along radial directions of the moving rods (51); and
a driving device (53) fixed in the top cover (20) and connected to the moving seat (52), the driving device (53) driving the moving seat (52) and the moving rods (51) to move relative to the top cover (20) along the axial direction of the moving rods (51) to drive the vacuum enclosure (41) to move relative to the top cover (20);
multiple vacuum pipes (60) mounted through the table (10), respectively mounted through bottom surfaces of the vacuum seats (43), and respectively communicating with the vacuum chambers (42) formed by the vacuum enclosures (41) for exhausting air from the vacuum chambers (42);
wherein the top cover (20) has two air curtain units (21) respectively being adjacent to the entry end (11) and the export end (12) of the table (10), and each of the air curtain units (21) has multiple vents (211) formed through a surface of the top cover (20) facing the table (10), the vents (211) of each of the air curtain units (21) arranged from the first side (13) to the second side (14) of the table (10) when the top cover (20) covers the table (10);
wherein the heating seats (30) have heating temperatures gradually higher from the entry end (11) to the export end (12); and
after each of the vacuum chambers (42) is under vacuum, formic acid gas is inputted into the vacuum chamber (42).
